## Europäisches Patentamt

## European Patent Office

## Office européen des brevets

(19)

(11) **EP 0 358 241 B2**

(12) # NEUE EUROPÄISCHE PATENTSCHRIFT

(45) Veröffentlichungstag und Bekanntmachung des Hinweises auf die Entscheidung über den Einspruch:
**30.07.1997 Patentblatt 1997/31**

(51) Int Cl.⁶: **G01D 5/20**

(45) Hinweis auf die Patenterteilung:
**21.04.1993 Patentblatt 1993/16**

(21) Anmeldenummer: **89118944.1**

(22) Anmeldetag: **11.02.1984**

(54) **Verfahren zur Messung einer Induktivität eines induktiven Sensors**

Method of determining inductivity of an inductive sensor

Procédé pour déterminer une inductance d'un capteur inductif

(84) Benannte Vertragsstaaten:
**AT CH DE FR GB IT LI NL SE**

(30) Priorität: **05.12.1983 DE 3343885**
**21.04.1983 DE 3314440**

(43) Veröffentlichungstag der Anmeldung:
**14.03.1990 Patentblatt 1990/11**

(62) Dokumentnummer(n) der früheren Anmeldung(en) nach Art. 76 EPÜ:
**84101422.8 / 0 126 846**

(73) Patentinhaber: **WABCO GmbH**
**30453 Hannover (DE)**

(72) Erfinder:
• **Ulbrich, Gerald**
**D-3000 Hannover 81 (DE)**
• **Neuhaus, Detlev**
**D-3012 Langenhagen (DE)**

(74) Vertreter: **Schrödter, Manfred, Dipl.-Ing.**
**WABCO GmbH**
**Postfach 91 12 80**
**30432 Hannover (DE)**

(56) Entgegenhaltungen:
**DE-A- 2 852 637**     **DE-A- 2 942 134**
**DE-A- 2 947 841**     **DE-A- 3 133 043**
**GB-A- 2 065 890**

• **PATENT ABSTRACTS OF JAPAN, vol. 19, no. 5, 4 Februar 1981 (E-044) & JP-A-55 146 955**

## Beschreibung

Die Erfindung bezieht sich auf ein Verfahren zur Messung einer Induktivität eines induktiven Sensors gemäß dem Oberbegriff des Patentanspruchs 1.

Bei derartigen Sensoren wird durch das Verschieben eines Eisenkerns die Induktivität einer Spule verändert. Durch eine Elektronik wird diese Veränderung erfaßt und in einen Weg umgeformt.

Gebräuchlich ist es, hierzu die Spule als frequenzbestimmendes Teil eines Schwingkreises einzusetzen [DE-OS 20 46 336]. Bei Induktivitätsveränderungen wird dann der Schwingkreis verstimmt. Die dadurch bewirkte Frequenzveränderung wird ausgewertet und analog in ein entsprechendes Wegsignal umgeformt.

Nachteilig an dieser Lösung ist es, daß die aktiven Bauteile des benötigten Oszillators temperaturabhängig sind, wodurch der Meßwert ungenau wird, insbesondere bei großen Temperatur-Schwankungen. Weiterhin ist die Beziehung zwischen Frequenz und Induktivität bzw. Weg des Eisenkerns mit $f = \frac{1}{2} \pi L \cdot C$ nicht linear, wodurch eventuell noch eine Korrektur-Schaltung notwendig wird.

Aus der DE-A-32 23 307 ist eine Meßschaltung für eine druckabhängig veränderliche Induktivität bekannt, bei welcher die Zeitdauer zwischen dem Zeitpunkt des Anlegens einer Spannung an die Wicklung der Induktivität und dem Anstieg des resultierenden Stromes auf einen vorgegebenen Pegel gemessen wird. Die Ansteuerung der Induktivität und die Auswertung (Zeitmessung) wird dabei von einem Mikrocomputer durchgeführt. Dieser steuert die Induktivität mit Spannungsimpulsen fester Frequenz und wechselnder Polarität an. Der Kern der Induktivität besteht dabei aus einem amorphen Material, welches stets bis in die Sättigung gefahren wird. Durch die Ansteuerung mit einer Wechselspannung kann es bei der bekannten Meßschaltung zu Hochfrequenz-Störungen kommen. Durch die Stromansteuerung bis in den Sättigungsbereich dauert es relativ lange, bis ein Einzelmeßwert vorliegt. Außerdem ist die Messung durch den nur noch langsamen Stromanstieg im Sättigungsbereich relativ ungenau.

Aus der DE-A 28 52 637 ist eine Auswerteschaltung für Induktivgeber bekannt, bei welcher die auszuwertende Induktivität mit einer Rechteckspannung konstanter Periodendauer, die von einem Oszillator geliefert wird, beaufschlagt wird. Die Aufladezeit der Induktivität bis zu einem Nulldurchgang der abfallenden Spannung wird gemessen und ist ein Maß für die Induktivität. Nachteilig dabei ist, daß die Periodendauer der Rechteckspannung relativ lang festgelegt werden muß, um auch große Induktivitätswerte messen zu können. Die Rechteckspannung wird dadurch bei der Messung von kleinen Induktivitäten schlecht ausgenutzt.

Der Erfindung liegt die Aufgabe zugrunde, einen Sensor der eingangs genannten Art so auszubilden, daß die obengenannten Nachteile vermieden werden. Weiterhin soll die Elektronik einfach und preisgünstig aufgebaut sein.

Diese Aufgabe wird durch die im Patentanspruch 1 enthaltende Erfindung gelöst. Die abhängigen Ansprüche enthalten zweckmäßige Weiterbildungen der Erfindung.

Die Zeichnung zeigt Ausführungsbeispiele der Erfindung.

**In Figur 1** ist schematisch der mechanische Teil des Sensors dargestellt.

**In Figur 2** ist die Auswerteelektronik dargestellt.

**In Figur 3a - d** ist ein Diagramm der Spannungen und Ströme der Elektronik nach Figur 2 über der Zeit dargestellt.

**In Figur 4** ist ein Schaltbild eines strombegrenzenden Schalters zu Figur 2 dargestellt.

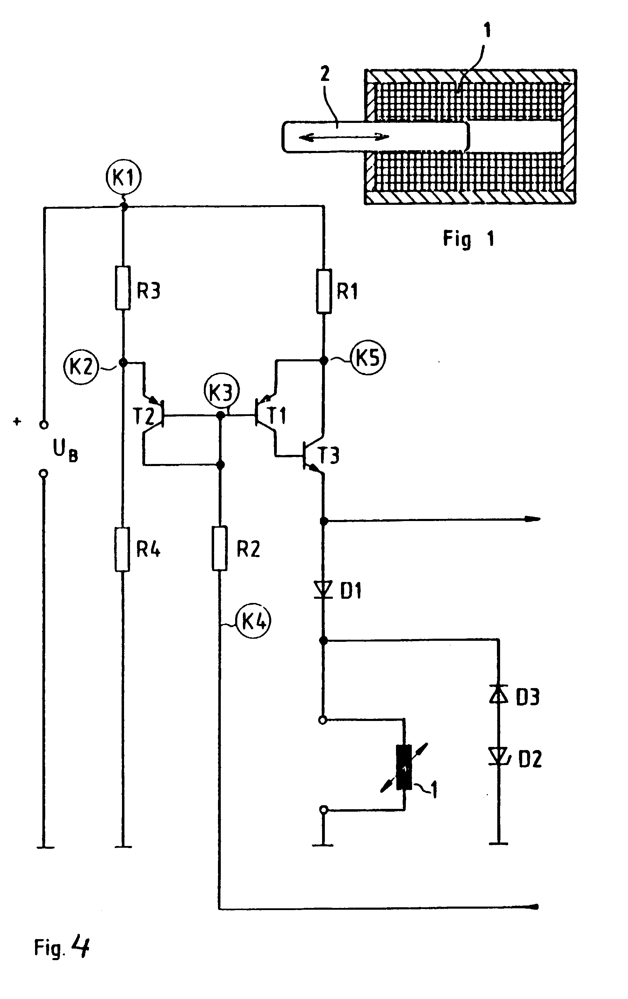

Der in Figur 1 schematisch dargestellte mechanische Teil des Sensors besteht aus einer Spule (1), in die ein beweglicher Kern (2), der z.B. aus Eisen besteht, entsprechend dem zu messenden Weg eingeschoben werden kann. Der mögliche Hub des Kerns (2) kann etwa 2 cm betragen. Das zu messende Bauteil kann auch über einen Hebel angelenkt sein, so daß auch größere Verschiebungen gemessen werden können.

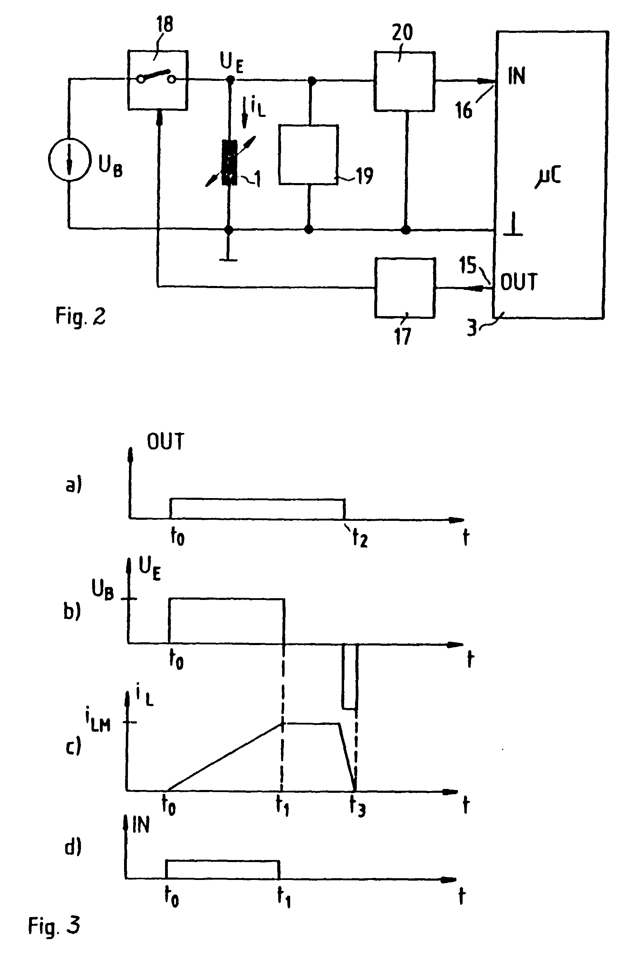

In Figur 2 ist als Blockschaltbild die Auswerteelektronik dargestellt. Über einen strombegrenzenden elektronischen Schalter (18) wird eine Betriebsspannung $U_B$ auf die Spule (1) gegeben. Der Schalter (18) wird über einen Eingangs-Pegelwandler (17) vom Mikrocomputer (3) [Ausgang (15), OUT] angesteuert. Dieser Ansteuer-Impuls dauert vom Zeitpunkt $t_0$ bis zum Zeitpunkt $t_2$ [siehe Fig. 3a]. Dabei fällt an der Spule (1) die Spannung $U_E = U_B$ ab [Fig.3b].

Sobald der Spulenstrom $i_L$ einen festgelegten Wert erreicht hat, z.B. 45 mA, wird dieser Strom durch den Schalter (18) begrenzt bzw. gehalten. Während dieser Zeit [$t_1 - t_2$] wird der Spannungsabfall an der Spule (1) nur noch vom ohmschen Widerstand bestimmt und ist vernachlässigbar klein. Anschließend wird der Spulenstrom von $t_2$-$t_3$ abgeschaltet. Der Zeitpunkt $t_2$ wird dabei vom Mikrocomputer (3) vorgegeben. Die dabei auftretende Spannung wird durch einen Abschalt-Begrenzer (19) auf einen ungefährlichen Wert, z.B. 45V, begrenzt. Das Zusammenbrechen der Spannung $U_E$ im Zeitpunkt $t_1$ wird nach einer Pegelwandlung im Ausgangspegelwandler (20) an den Mikrocomputer (3) weitergeleitet. Dieser beendet dann die Abarbeitung des Zeitmeßprogramms und hält für die weitere Verarbeitung das Meßergebnis $t_1 - t_0$, das proportional der Spulen-Induktivität ist, als Zahlenwert bereit.

Um den laufenden Meßvorgang abzuschließen und den nächsten Meßvorgang vorzubereiten, schaltet der Mikrocomputer das OUT-Sigual und damit $U_E$ und $i_L$ ab. Die Abschaltenergie der Spule (1) wird durch den Abschaltbegrenzer (19) in kurzer Zeit und mit unschädlicher Spannungsspitze aufgenommen.

In Figur 4 ist der linke Teil der Schaltung nach Figur 2 mit dem strombegrenzenden elektronischen Schalter (18), der Spule (1) und dem Abschaltbegrenzer (19) genauer dargestellt.

Der strombegrenzende Schalter (18) besteht aus einer Steuerspannungsquelle (T2, R2, R3, R4) und aus einer spannungsgesteuerten Stromquelle (T1, T3, R1, D1).

Die Stromquelle setzt die zwischen den Schaltknoten K3 und K1 bestehende Steuerspannung proportional in einen Ausgangsstrom $i_L$ um. Der Regeltransistor T1 führt die Spannung an R1 der Steuerspannung nach. Der Transistor T3 dient hierbei als Stromverstärker. Die Diode D1 stellt einen Schutz gegen Überspannungen dar.

Die Steuerspannungsquelle leitet aus der Versorgungsspannung $U_B$ die Vergleichsspannung $U_{K2-K1}$ ab. Aus dieser wird die o.g. Steuerspannung $U_{K3-K1}$ abgeleitet. Diese weist die folgenden drei Zustände auf.

a) **Abgeschaltet**: Der Ausgang OUT des Mikrocomputers (3) hat den Wert 0 und legt den Knoten K4 mittels des Eingangspegelwandlers (17) auf das Potential von K1. Deshalb sperrt der Transistor T2 den Koten K3 gegen K2 ab und die Steuerspannung ist Null. Die Transistoren T1 und T3 sind infolgedessen gesperrt.

b) **Schwimmend**: Der Ausgang OUT hat den Wert 1 und legt den Knoten K4 über den Eingangspegelwandler (17) auf Massepotential. Dadurch fließt über R1, T1 [Emitter-Basis-Strecke] und R2 ein geringer Strom, der die Transistoren T1 und T3 voll öffnet. Da infolge der Selbstinduktivität der Spule (1) [siehe Bild 6] der Strom $i_L$ und damit die Spannung $U_{K5-K1}$ von Null aus und die Spannung $U_{K3-K1}$ von ca. 0,6 Volt aus rampenförmig ansteigen, ist T2 zunächst gesperrt, da er durch die Spannung $U_{K2-K1}$ vorgespannt ist. In diesem Zustand "schwimmt" das Potential am Knoten K3 mit dem von K5 mit.

c) **Begrenzt**: Der Ausgang OUT hat weiterhin den Wert (1). Nach dem Durchlaufen des Zustandes b) ist $i_L$ so groß geworden, daß die Vorspannung an T2 zum Sperren nicht mehr ausrecht. Dadurch, daß T2 nun leitend wird, wird der von K3 über R2 nach K4 abfließende Strom nicht mehr allein von T1 geliefert. Dies bedeutet, daß T1 und T3 nicht mehr voll durchgesteuert sind, sondern nur soweit, daß die Spannung $U_{K5-K1}$ genau so groß wie die Vergleichsspannung $U_{K2-K1}$ wird. Dadurch stellt sich die Begrenzung des Spulenstroms $i_L$ auf den Wert

$$i_{LM} = \frac{1}{R1} \cdot U_{K1-K2}$$

ein.

Die Transistoren T1 und T2 sind thermisch gekoppelt, so daß sich eine Temperaturkompensation der Basis-Emitter - Spannungen von T1 und T2 einstellt. Der Wert $i_{LM}$ ist also temperaturstabil.

Der Abschaltbegrenzer (19) wird durch die Dioden D3 und D2 gebildet. D3 hält die während des Stromanstiegs an Spule und Abschaltbegrenzer anliegend positive Spannung von der Zener-Diode D2 fern.

Beim Auftreten der vom Zusammenbrechen des Spulenfeldes herrührenden hohen negativen Abschaltspannung wird D3 leitend. Die Zener-Diode D2 kann nun zur Wirkung kommen.

Die Abschaltspannungsspitze wird auf die Summe von Zenerspannung (D2) und Durchlaßspannung (D3) begrenzt.

Die Begrenzungsspannung beeinflußt die Abbaugeschwindigkeit des Spulenstromes $i_L$. Da sie betragsmäßig viermal so groß wie die den Stromaufbau bewirkende Versorgungsspannung $U_B$ ist, geht der Stromabbau etwa viermal so schnell vonstatten. Dadurch ist die Anordnung in kurzer Zeit für einen neuen Meßvorgang bereit.

## Patentansprüche

1. Verfahren zur Messung einer Induktivität eines induktiven Sensors, insbesondere zur Wegmessung, mit einer Spule (1), einem bezüglich zur Spule (1) verschiebbaren Kern (2) und einer Elektronik, welche die jeweilige wegabhängige Induktivität der Spule (1) auswertet, wobei die Elektronik einen Mikrocomputer (3) enthält, welcher die Spule (1) mit einem Spannungsstoß anregt und aus dem resultierenden Ladestrom mittels einer Zeitmessung eine von der Verschiebung des Kerns (2) abhängige Induktivitätsgröße der Spule (1) ermittelt, gekennzeichnet durch folgende Merkmale:

a) die Spule (1) wird im Zeitpunkt (t0) mittels eines vom Mikrocomputer (3) ansteuerbaren strombegrenzenden elektronischen Schalters (18) mit einer Spannungsquelle ($U_B$) verbunden;

b) die Aufladezeit der Spule (1) bis zum Einsetzen der Strombegrenzung (t0-t1) wird vom Mikrocomputer (3) ausgewertet und in eine wegabhängige Größe umgerechnet;

c) nach einer vom Mikrocomputer (3) vorgegebenen Zeit (t2) wird der elektronische Schalter (18) vom Mikrocomputer (3) wieder abgeschaltet;

d) die Meßvorgänge erfolgen nur zu bestimmten, vom Mikrocomputer ausgewählten Zeitpunkten;

e) die Ansteuerung des strombegrenzenden elektronischen Schalters (18) erfolgt über einen Eingangspegelwandler (17);

f) die Übermittlung der Aufladezeit der Spule (1) an den Mikrocomputer (3) erfolgt über einen Ausgangspegelwandler (20);

g) die Spule (1) ist an einen Abschaltbegrenzer (19) angeschlossen;

h) der strombegrenzende elektronische Schalter (18) besteht aus einer Steuerspannungsquelle (T2, R2, R3, R4) und einer nachgeschalteten spannungsgesteuerten Stromquelle (T1, T3, R1, D1).

2. Verfahren nach Anspruch 1, dadurch gekennzeichnet, daß die Steuerspannungsquelle einen Transistor T2 und die spannungsgesteuerte Stromquelle einen Transistor T1 enthält und die Transistoren T1 und T2 thermisch gekoppelt sind.

3. Verfahren nach wenigstens einem der Ansprüche 1 bis 2, dadurch gekennzeichnet, daß der Kern (2) mit einer Druck-Membran verbunden ist.

4. Verfahren nach Anspruch 1 bis 3, dadurch gekennzeichnet, daß durch den Mikrocomputer (3) eine softwaremäßige Linearisierung des Meßwertes durchgeführt wird.

Claims

1. Method for measuring the inductance of an inductive sensor, especially for measuring displacement, having an inductor (1), a core (2) displaceable relative to the inductor (1) and electronics that evaluate the particular displacement-dependent inductance of the inductor (1), the electronics containing a microcomputer (3) that excites the inductor (1) by a voltage pulse and determines from the resulting charging current by means of a time measurement an inductance parameter of the inductor (1), which parameter is dependent on the displacement of the core (2),
characterised by the following features:

a) the inductor (1) is connected at a time point (t0) by means of a current-limiting electronic switch (18) controlled by the microcomputer (3) to a voltage source ($U_B$);

b) the charging time of the inductor (1) ) up to the onset of current limitation (t0-t1) is evaluated by the microcomputer (3) and converted into a displacement-dependent parameter;

c) after a period (t2) predetermined by the microcomputer (3), the electronic switch (18) is switched off again by the microcomputer (3);

d) the measurements are carried out only at specific time points selected by the microcomputer;

e) the current-limiting electronic switch (18) is controlled through an input level converter (17);

f) the charging time of the inductor (1) is transmitted to the microcomputer (3) by way of an output level converter (20);

g) the inductor (1) is connected to a switch-off limiter (19);

h) the current-limiting electronic switch (18) consists of a control voltage source (T2, R2, R3, R4) and a downstream voltage-controlled current source (T1, T3, R1, D1).

2. Method according to claim 1, characterised in that the control voltage source contains a transistor T2 and the voltage-controlled current source contains a transistor T1 and the transistors T1 and T2 are thermally coupled together.

3. Method according to at least one of claims 1 and 2, characterised in that the core (2) is connected to a pressure membrane.

4. Method according to claims 1 to 3, characterised in that the microcomputer (3) effects through software a linearisation of the measured value.

Revendications

1. Procédé pour mesurer une inductance d'un capteur inductif, en particulier en vue de la mesure d'une distance, avec une bobine (1), un noyau (2) déplaçable par rapport à la bobine (1), et avec une électronique qui évalue l'inductance en fonction de la distance de la bobine (1), ladite électronique comportant un micro-ordinateur (3), qui excite la bobine (1) avec une impulsion de tension, et qui, au moyen du courant de charge résultant, détermine une valeur d'inductance de la bobine (1) dépendant du déplacement du noyau (2),
caractérisé par les caractéristiques suivantes :

a) à l'instant ($t_0$), la bobine (1) est reliée à une source de tension ($U_B$) au moyen d'un interrupteur électronique limiteur de courant commandé par le micro-ordinateur (3);

b) le temps de charge de la bobine (1), temps (t0 - t1) écoulé jusqu'à l'établissement de la limitation de courant est évalué par le micro-ordinateur (3) et converti en une grandeur dépendant du déplacement;

c) après un temps (t2) prédéterminé par le micro-ordinateur (3), l'interrupteur électronique (18) est réouvert par le micro-ordinateur (3);

d) les processus de mesure ne s'effectuent qu'à des instants déterminés choisis par le micro-ordinateur;

e) la commande de l'interrupteur électronique limiteur de courant (18) s'effectue par l'intermédiaire d'un convertisseur de niveau d'entrée (17);

f) la transmission du temps de charge de la bobine (1) au micro-ordinateur (3) s'effectue par l'intermédiaire d'un convertisseur de niveau de sortie (20);

g) la bobine (1) est reliée à un limiteur d'effet de coupure (19);

h) l'interrupteur électronique limiteur de courant (18) est constitué par une source de tension de commande (T2, R2, R3, R4) et par une source de courant (T1, T2, R1, D1) disposée en aval et commandée en tension.

2. Procédé selon la revendication 1, caractérisé en ce que le source de tension de commande comprend un transistor T2 et la source de courant commandée en tension un transistor T1, et les transistors T1 et T2 sont couplés thermiquement.

3. Procédé selon l'une quelconque des revendications 1 et 2, caractérisé en ce que le noyau (2) est relié à une membrane pouvant être soumise à une pression.

4. Procédé selon l'une quelconque des revendications 1 à 3, caractérisé en ce qu'une linéarisation algorithmique de la valeur mesurée est effectuée par le micro-ordinateur (3).

Fig 1

Fig. 4

Fig. 2

Fig. 3